# EUROPEAN PATENT APPLICATION

(11) **EP 2 039 665 A2**
(43) Date of publication of application: **25.03.2009**
(21) Application number: 08252706.0
(22) Date of filing: 15.08.2008
(51) Int. Cl.: C04B 35/447

(54) **Method of producing a lithium phosphate sintered body and sputtering target**

(30) Priority: 17.08.2007 JP 2007212756
(71) Applicant: Ulvac Materials Inc., Chiba 286-0225 (JP)
(72) Inventor: Kim, Poong, Chiba, 286-0225 (JP); Nakajima, Hideaki, Chiba, 286-0225 (JP); Ito, Manabu, Chiba, 286-0225 (JP); Hidaka, Kouji, Chiba, 286-0225 (JP); Oginosawa, Takaoshi, Chiba, 286-0225 (JP); Hashiguchi, Shouichi, Chiba, 286-0225 (JP); Mikashima, Takanori, Chiba, 286-0225 (JP)
(74) Representative: Albutt, Anthony John

(57) **Abstract**

To attain a method of producing a lithium phosphate sintered body and a sputtering target capable of providing a high-density bulk body with no macro-size internal defect, the present invention provides a method of producing a lithium phosphate sintered body, including the steps of: calcining raw material powder of Li₃PO₄ at a temperature set to be 650°C or more and less than 850°C; pulverizing and sieving the calcined raw material powder; and sintering the sieved raw material powder to a predetermined shape. By setting a calcining temperature of the raw material powder to be 650°C or more and less than 850°C, moistures absorbed to the raw material powder are effectively removed and generation of macro-size internal defects in the resultant bulk (sintered) body is suppressed. When the calcining temperature is less than 650°C, calcining processing is insufficient, so generation of macro-size internal defects cannot be suppressed effectively. Particularly for ease in pulverizing and sieving to obtain particle sizes of 400 µm or less, the calcining temperature is preferably set to be 650°C or more and 750°C or less.

## Description

### Background of the Invention

### 1. Field of the Invention

The present invention relates to a method of producing a lithium phosphate sintered body and a sputtering target which are used in producing a solid electrolyte constituting a thin-film lithium secondary battery, for example.

### 2. Description of the Related Art

In recent years, thin-film lithium secondary batteries using inorganic solid electrolytes are being developed. An LiPON thin film is an example of the inorganic solid electrolyte highly expected in the future. The LiPON film can be formed by reactive sputtering of lithium phosphate (Li₃PO₄) under a nitrogen (N₂) gas atmosphere.

Film deposition by sputtering is one of techniques of physical vapor deposition (PVD) and involves discharging a sputtering gas in a vacuum apparatus applying power of direct current (DC) or alternating current (RF, AC), and generating ions thereof to collide with a sputtering target to thus deposit a film of a target constituent on a substrate. Examples of the target materials are a single metal, an alloy, an oxide, and a compound. As a method of producing a sputtering target, those are generally employed a production method that involves melting and casting (see, for example, Japanese Patent Application Laid-open No. 2005-36268) and a production method that involves sintering raw material powder (see, for example, "Effects of sputtering pressure on the characteristics of lithium ion conductive lithium phosphorous oxynitride thin film", Ho Young Park, et al., J Electroceram, 2006, 17:1023-1030)(hereinafter, referred to as Non-patent Document 1).

The following issues are required to satisfy the quality of the sputtering target. First, microstructure should be fine with crystal grain size distribution thereof narrow (i.e., average crystal grain size is small and grain size distribution is sharp), and concentration distribution of constituents is also needed to be uniform. Second, impurity levels should be controlled. Finally, when using powder as the raw material, the sputtering target should have a high density with a relative density of 95% or more. Here, the relative density refers to a ratio of a density of a porous body to a density of a material having the same composition but with no pores (the same holds true in the descriptions hereinafter).

Generally, lithium batteries and lithium-ion batteries are known to avoid influences of moisture absorption as much as possible. As the Li₃PO₄ itself used in forming a solid electrolyte is known to hydrate 5 mol of H₂O with respect to 1 mol of Li₃PO₄ at room temperature, it is thus difficult to remove moistures unless heating with high ignition temperature. Furthermore, because the Li₃PO₄ itself easily undergoes hydrolysis, moisture absorption needs to be suppressed as much as possible in production of a bulk for a target used in sputtering, and also in storage of the bulk thereafter.

A sintering technique is used as a technique of forming a bulk with powder as the raw material.

The technique is referred to as powder metallurgy method when the raw material powders are metal and metal-nonmetal-based powders. The powder metallurgy methods are roughly divided into two types, one is applying heat and pressure simultaneously (hot isostatic pressing (HIP) method or hot pressing (HP) method), and the other is applying heat to a preliminary formed compact (in this case, the technique is often, and will be in the specification, referred to as "sintering method"). In either method, sintering of powder progresses during heating to thus improve a density and stiffness of a sintered body.

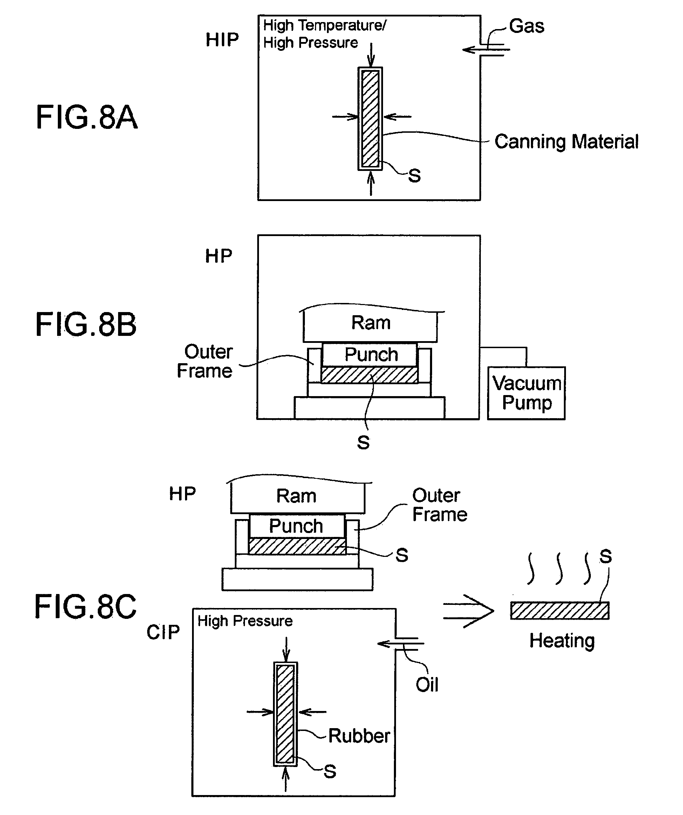

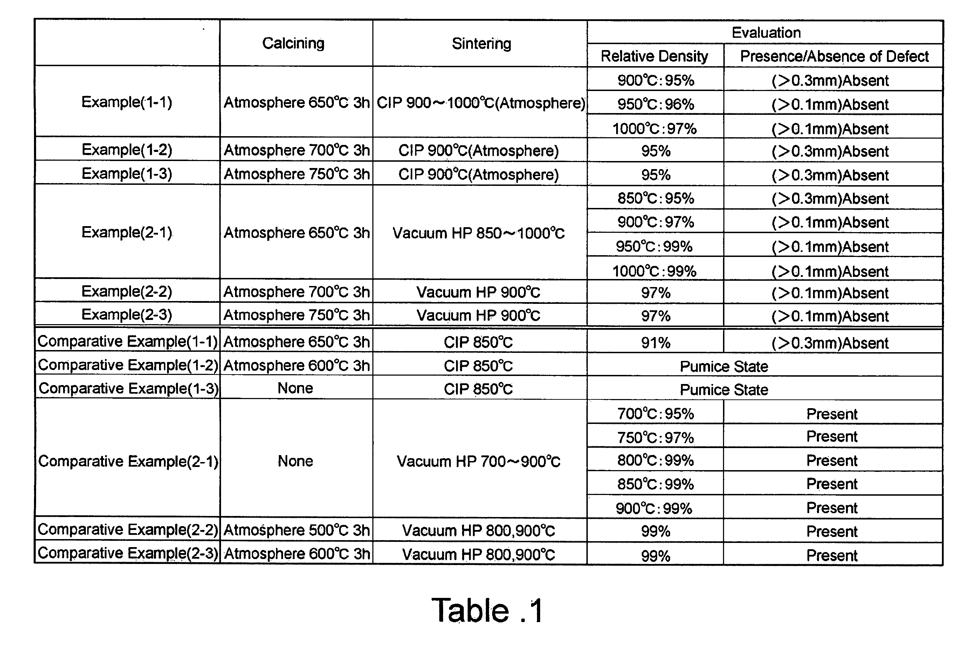

As shown in Fig. 8A, the hot isostatic pressing method involves filling a can (vessel made of thin metal plate or foil) with raw material powder and degassing from raw material powder and can material before sealing it shut, and heating and pressurizing an object S with an inert gas such as argon inside a large pressurized vessel under a hydrostatic pressure, to thus obtain a sintered body. As shown in Fig. 8B, the hot pressing method involves filling a mold made of carbon or a metal with the raw material powder, and pressurizing the raw material powder at a predetermined temperature so that sintering progresses to thus obtain a sintered body S. The hot pressing method can be carried out in the atmosphere, but is more often carried out under a vacuum atmosphere created by using a vacuum pump or an atmosphere substituted by argon gas or the like, in consideration of degradation of a mold material and ease in degassing. As shown in Fig. 8C, the sintering method involves forming the raw material powder into a preliminary compact S by a die pressing method or a cold isostatic pressing (CIP) method, and after that, maintaining the preliminary compact S at a high temperature to thus obtain a sintered body. The sintering method is carried out under an atmospheric pressure or under an atmosphere obtained by introducing oxygen into the atmospheric pressure.

The sintering technique described above is similarly applied in a case where the raw material powder is a nonmetal powder or a compound. But, when the raw material powder is an oxide or a compound, a large amount of sorption gas may be released. Further, dissociation may be taken place when the raw material powder is an oxide or a compound. The outgassing and the dissociation make it difficult to apply the hot isostatic pressing method which means enclosing the can into a closed pressurized vessel or the hot pressing method carried out under the vacuum atmosphere. Then the sintering method is often used when the raw material powder is an oxide or a compound.

As described above, as for the quality required for the sputtering target produced by the sintering, the density should be high (95% or more). The sintered body with a relative density of less than 95% has pores coupled continuously and an increased specific surface area thereof exposed to the vacuum. Accordingly, amount of outgassing increases. Thus, a longer time is required for evacuating the chamber including the target, until pressure reaches an ultimate vacuum pressure. Moreover, when the absorbed water that increases along with the increase in specific surface area is discharged during sputtering film deposition, moistures are trapped in the film, and the film having required quality cannot be stably reproduced. In particular, for suppressing inconveniences caused by moisture absorption (local dissolution of Li₃PO₄, prolonged evacuation, and deterioration of a film quality) when forming a film using a lithium material for a thin-film battery by the sputtering technique, it is essential to prepare a high-density bulk.

However, it has been found that the sintering method causes an extremely low density in the sintered body whereas the vacuum hot pressing method causes an internal defect of a several millimeters (mm) or more in diameter in the sintered body.

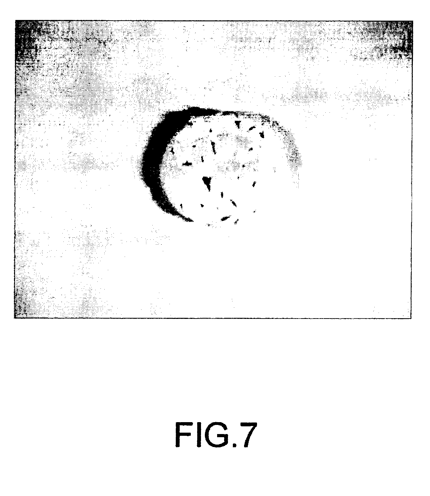

Specifically, a sintered body produced by heating press-mold compact using commercially-available Li₃PO₄ powder having an average grain size of 7 µm under the atmosphere or the oxygen atmosphere showed that a relatively large amount of macro pores still remained in the obtained sintered body sample, and the sample was not of a level sufficient for measuring the relative density. An appearance of the sample in this case is shown in Fig. 7. Further, the same process as that described above while using commercially-available granulated raw material powder having a larger grain size than the Li₃PO₄ powder resulted in the relative density of about 80% under the same heating condition.

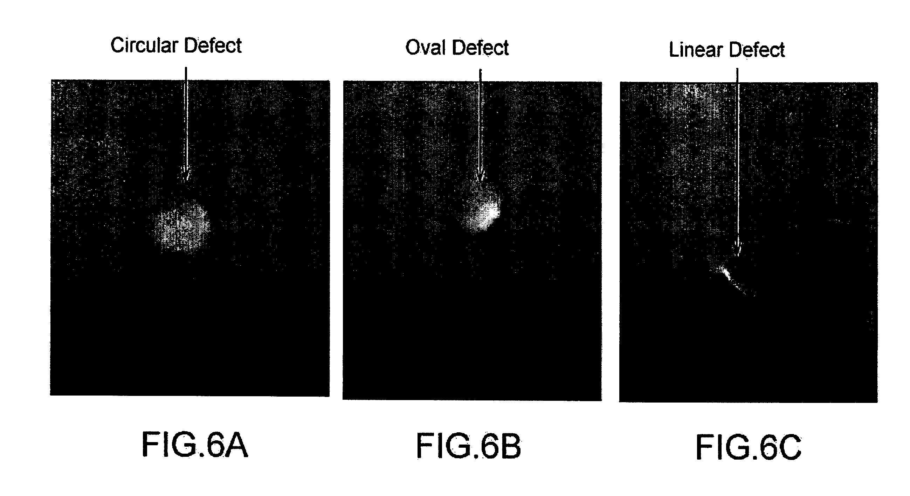

Meanwhile, a sintered body sample was obtained using the vacuum hot pressing method, which is usually considered to be not suitable for the oxides sintering. In this case, longer time for overall heating process was set, as the retention time was introduced at the middle temperature in heating to remove absorbed or contained gas. As a result, a relative density of 99% was achieved in an Li₃PO₄ plate sample experimentally produced with a temperature set to 800°C during pressing. However, after machining the sample for preparing a sputtering target, it has been found that internal defects (pores) each of a several millimeters in diameter still remained in the bulk plate. Moreover, it has also been found out that several to several tens of similar internal defects are observed during machining of another sample to reduce a thickness from 8 mm to 5 mm. An example of the internal defects are respectively shown in Figs. 6A to 6C. Here, types of the defects are categorized in accordance with external configurations thereof. Fig. 6A shows a circular defect, Fig. 6B shows an oval defect, and Fig. 6C shows a linear defect.

The facts above lead to a speculation that during the sintering process, due to a gas adhered or absorbed to the raw material powder or the hydrated gas , a pumice state (Fig. 7) was caused defects whereas circular, oval, or linear (Figs. 6A to 6C) each of a several-millimeter-size in diameter were caused in the vacuum hot pressing method.

As described above, it is extremely important in view of stably forming an LiPON film and improving efficiency of the film deposition process that no internal defect of a macro-size (mmϕ) or more exist and the relative density is maintained at 95% or more when using the Li₃PO₄ bulk plate (sintered body) as the sputtering target. However, for achieving the above-mentioned object, it is necessary to optimize modification of the raw material powder and conditions for producing bulk plates.

It should be noted that Non-patent Document 1 includes descriptions on the process of producing an Li₃PO₄ sintered body target for an experimental use. Specifically, the process involves pulverizing and sieving the raw material powder calcined at 850°C or more to adjust particle sizes to a certain size or less, and after pressing the powder, sintering them at 950°C. This process, however, has a problem that a great amount of time and effort is required in the process of calcining and pulverizing the powder. Specifically, as the calcining temperature of the powder increases, particles of the powder cure more and more, and it becomes difficult to properly carry out the pulverization process thereafter, and then, a relative density of the resultant bulk body may decrease.

### Summary of the Invention

The present invention has been made in view of the above-mentioned problems, and it is therefore an object of the invention to provide a method of producing a lithium phosphate sintered body and a sputtering target having a high relative density with no macro-size internal defect.

An embodiment of the present invention provides a method of producing a lithium phosphate sintered body, including the steps of: calcining raw material powder of Li₃PO₄ at a temperature set to be 650°C or more and less than 850°C; sieving the calcined and pulverized raw material powder; and sintering the raw material powder to a predetermined shape.

### Brief Description of Drawings

Fig. 1 is a flowchart showing a process flow for illustrating a method of producing a lithium phosphate sintered body according to an embodiment of the present invention;
Fig. 2 is a graph showing a result of a thermogravimetric measurement of a single raw material powder sample of Li₃PO₄;
Fig. 3 is a graph showing a result of a thermal desorption test of the single raw material powder sample of Li₃PO₄;
Figs. 4 are diagrams showing a relationship between modification temperatures and full width at half maximum (FWHM) of XRD analysis of two different Li₃PO₄ samples;
Fig. 5 is a schematic structural diagram of a cathode portion in magnetron sputtering apparatus;
Figs. 6 are photos of typical features of an internal defects in the lithium phosphate sintered body;
Fig. 7 is a sample picture of the lithium phosphate sintered body in a pumice state; and
Figs. 8 are schematic diagrams for illustrating a method of sintering powder, in which Fig. 8A shows a hot isostatic pressing method, Fig. 8B shows a vacuum hot pressing method, and Fig. 8C shows a sintering method.

### Description of Preferred Embodiments

A method of producing a lithium phosphate sintered body includes the steps of: calcining raw material powder of Li₃PO₄ at a temperature set to be 650°C or more and less than 850°C; pulverizing and sieving the calcined raw material powder; and sintering the sorted raw material powder to a predetermined shape.

In the method of producing a lithium phosphate sintered body, by defining the temperature for calcining the raw material powder, moisture absorbed in the raw material powder are efficiently removed and formation of macro-size internal defect in a bulk body (sintered body) obtained by the sintering process is suppressed. When the temperature for calcining is less than 650°C, the calcining effect on the raw material powder is insufficient, and the formation of macro-size internal defects thus cannot be suppressed efficiently. Further, although higher temperature for calcining induces higher effects, higher processing temperature cures the raw material powder more and more, whereby pulverization and sieving may not be carried out easily. Thus, an upper limit of the temperature for calcining is set to be less than 850°C. By setting the temperature for calcining to be 650°C or more and 750°C or less, the raw material powder becomes possible to be easily pulverized and the sieved raw material powder having a maximum particle size of 400 µm or less are easily prepared.

The sintering process may be carried out by two processes of a press molding process and then a heating process as in the sintering method, but may also be carried out by a single process as in the hot pressing method. As the press molding process, for example, a CIP method is applicable. An atmospheric condition may either be under the atmosphere or under the vacuum atmosphere, and the sintering method may employ, for example, the condition of under the atmosphere whereas the hot pressing method may employ, for example, the condition of under the vacuum atmosphere. Regarding the temperature for sintering, the sintering method may employ a temperature set to be, for example, 900°C or more and 1000°C or less whereas the hot pressing method may employ a temperature set to be, for example, 850°C or more and 1000°C or less.

The lithium phosphate sintered body produced as described above can suppress formation of internal defects due to moisture absorption while providing a relative density of 95% or more. Therefore, the use of the sintered body as a sputtering cathode prevents moisture discharge during film deposition and enhances stability during electrical discharge.

Hereinafter, an embodiment of the present invention will be described with reference to the drawings. It should be noted that the present invention is not limited to the following embodiment and may be variously modified based on the technical idea of the present invention.

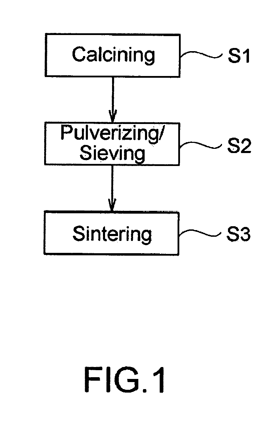

Fig. 1 is a flowchart showing a process flow for illustrating a method of producing a lithium phosphate sintered body according to the embodiment of the present invention. The method of producing a lithium phosphate sintered body of this embodiment includes calcining raw material powder of Li₃PO₄ (S1), pulverizing and sieving the calcined raw material powder (calcined powder) (S2), and sintering the sieved powder to a predetermined shape (S3). The resultant lithium phosphate sintered body is used as a sputtering target for an LiPON film deposition, for example.

### (Calcining process)

Raw material powder made of lithium phosphate (Li₃PO₄) have high moisture absorbability at room temperature, and cause a number of macro internal defects each having a size of a several millimeters in diameter within a resultant bulk body (sintered body) when the raw material powder is sintered without being calcined, thus disabling an increase in relative density. To prevent the formation of internal defects, the raw material powder is subjected to calcining before sintering. As will be described later, a temperature for calcining is preferably set to be 650°C or more and less than 850°C, and more preferably set to be 650°C or more and 750°C or less. In addition, although not particularly limited, a processing time can be set to be, for example, about 0.5 to 1 hour or more after reaching a retention temperature.

### (Pulverizing/sieving process)

The calcining processing at a high temperature makes it easy to progress of the sintering of the raw material powder. Thus, it becomes impossible to prevent enlargement of particle sizes. On the other hand, the smaller the particle size is, the lower the temperature required for the sintering to progress is, in general. Accordingly, there is a need to pulverize and sieve the calcined powder into those of appropriate sizes when carrying out the sintering process. A well-known pulverizer such as a roll mill and a ball mill can be used to pulverize the calcined powder. A filter having a suitable opening area can be used for sieving the powder into those having appropriate particle sizes. For example, a 32-mesh (#32) filter is used to adjust a maximum particle size of the powder to 400 µm or less.

### (Sintering process)

The sintering process may be carried out by two processes of a press molding process and then a heating process as in a sintering method, but may also be carried out by a single process as in a hot pressing method. As the press molding process, for example, a CIP method is applicable. An atmospheric condition may either be under the environmental atmosphere or under a vacuum atmosphere, and the sintering method prefers the condition of under the environmental atmosphere whereas the hot pressing method prefers the condition of under the vacuum atmosphere.

Regarding the temperature for heating, the sintering method can employ a temperature set to be, for example, 900°C or more and 1000°C or less. When the temperature for heating is less than 900°C, it becomes difficult for the sintered body to achieve higher relative density 95% or more. Whereas, when the temperature fore heating is over 1000°C, the crystal grain coarsening may takes place, and localized melting down may takes place as the temperature become close to the melting point of the powder. On the other hand, the hot pressing method can employ a temperature set to be, for example, 850°C or more and 1000°C or less. When the heating temperature is less than 850°C, there is a fear that a high-density sintered body having a relative density of 95% or more may be difficult to be obtained, whereas when the heating temperature exceeds 1000°C, there is a fear that melting of the powder may be caused. The processing time can be set to be, for example, 2 hours or more and 6 hours or less, or furthermore, 2 hours or more and 4 hours or less.

Next, temperature conditions optimal for the calcining processing will be discussed.

The cause of the internal defects formation in the sintered body depends on characteristics of the raw material powder. The calcining processing means modification of the raw material powder that is carried out to remove a gas adhering to or absorbed in the raw material powder or a hydrated gas and also remove influences of cohesive particles. Thus, to specify optimal calcining conditions, an XRD (X-ray diffraction) analysis of calcined powder as well as a thermogravimetric measurement and a thermal disorption test of the raw material powder were conducted. As the raw material powder, Li₃PO₄ powder each having an average grain size of 7 µm available from Sigma-Aldrich Co. (product No.: 338893) (hereinafter, referred to as Sample A) and granulated Li₃PO₄ powder available from KANTO CHEMICAL CO., INC. (product No.: 24137-01) (hereinafter, referred to as Sample B) were used.

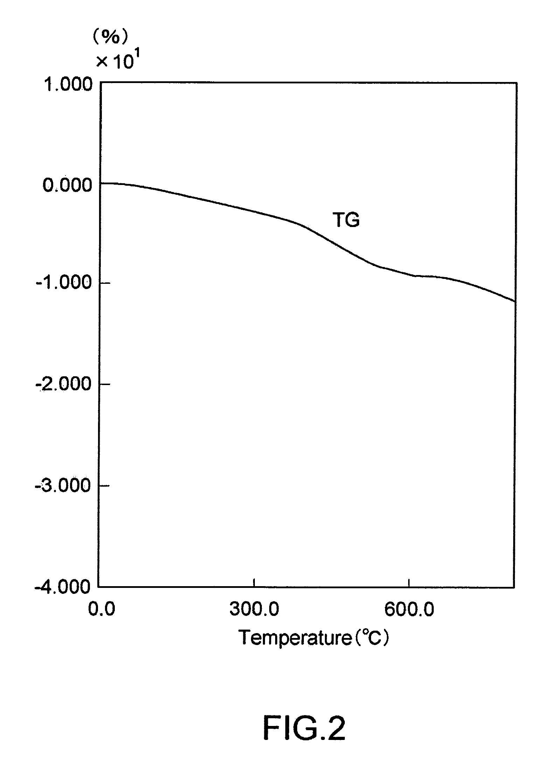

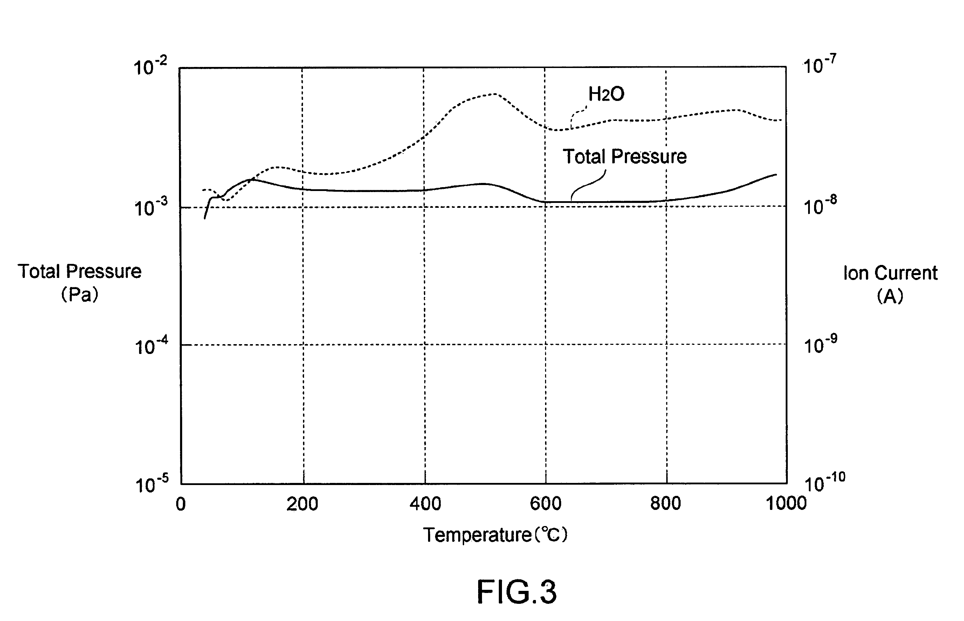

Figs. 2 and 3 show results of the thermogravimetric measurement and thermal desorption test, respectively, regarding Sample A. In Fig. 2, "TG" represents a thermogravimetric change of the sample. In Fig. 3, the term "total pressure" refers to a pressure in a vacuum chamber in which the heated sample is placed, and the term "ion current" refers to an ion current value measured by a mass spectrometer in association with a moisture (H₂O) amount desorbed from the heated sample.

It can be seen from the result of the thermogravimetric measurement of the raw material powder shown in Fig. 2 that the mass is drastically decreased between the temperatures of 450°C and 600°C. On the other hand, it can be seen from the result of the thermal desorption test shown in Fig. 3 that a large amount of moistures (H₂O) are desorbed between the temperatures of 400°C and 600°C with 500°C as a desorption peak.

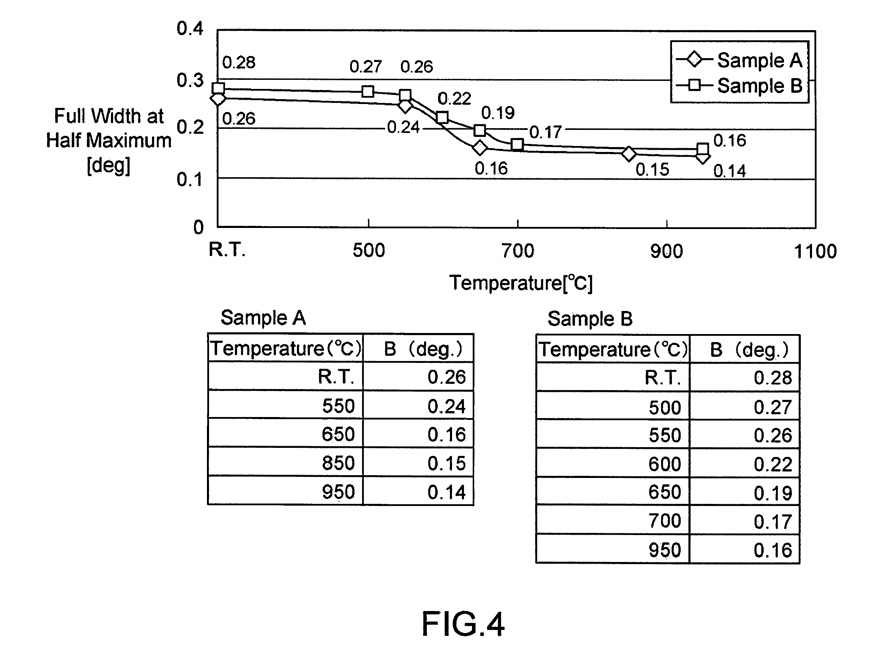

In addition, XRD profiles (radiation source: Cu) were measured for the raw material powder and the calcined powder obtained by subjecting the raw material powder to the calcining processing at predetermined temperatures ranging from 500°C to 950°C, to thus find out value changes of full width at half maximum (FWHM) of a main peak ((012) orientation), which corresponds to an Li₃PO₄ crystal, at an angle 2θ = 22.3° to 22.4° at which a diffraction is detected, an irradiation angle of the X-rays with respect to the raw material powder being represented by θ. As a result, as shown in Figs. 4, the FWHM of both Samples A and B become smaller as the temperature for calcining increases. In particular, regarding Sample B, a FWHM of non-processed raw material powder (R.T.: room temperature) was 0.28° while the FWHM of the powder calcined at 500°C was 0.27°, that of the powder calcined at 600°C was 0.22°, and that of the powder calcined at 700°C was 0.17°.

It should be noted that almost no difference was visually observed between the powder processed at 600°C, and the non-processed powder. However, a significant difference was recognized from the result of the XRD diffraction analysis. Further, regarding the powder calcined at 700°C, based on the fact that the sintering progresses and compaction takes place and the FWHM is reduced, it has been confirmed that the powder is in grown up state where crystal itself is more stable.

However, a sintered body produced by the vacuum hot pressing method at 800°C using the powder calcined at 600°C resulted in existence of internal defects of mm size even though the relative density was 99%. As a result, it should be concluded that the calcining processing at 600°C based on the result of the thermogravimetric measurement shown in Fig. 2 is insufficient for the modification of the raw material powder.

On the other hand, a sintered body was produced by the vacuum hot pressing method at 900°C using the powder calcined at 700°C based on the XRD analysis result. At this time, because the sintering is progressed in the calcining processing at 700°C, the maximum particle size of the calcined powder is adjusted to about 400 µm by carrying out the pulverization processing using the roll mill and sieving the powder using the 32-mesh (#32) filter. The relative density of the resultant sintered body was 97%, but no internal defect exceeding a millimeter-size was observed, and the maximum internal defect observed was 0.3 mmϕ.

Generally, the smaller the particle size is, the lower the temperature at which the sintering progresses is. Thus, the sintering and crystal grain growth during calcining are desirably suppressed of its progression as much as possible. When carrying out the sintering process by the vacuum hot pressing method at a low temperature (800°C) using the powder calcined at 500°C and 600°C, a maximum relative density (99%) was obtained although internal defects were still remained. On the other hand, in the vacuum hot pressing method using the powder calcined at 700°C, the relative density of the sintered body was found to increase as the pressing temperature increased, and the maximum relative density (99%) was obtained at 950°C. No macro pores (internal defects of a millimeter-size) were formed in the sintered body.

It should be noted that in the sintering process by the sintering method, when the raw material powder is used without being subjected to the calcining processing, a density distribution was caused and only a low-density sintered body was obtained. However, by using the raw material powder calcined at 700°C, pulverized, and sieved, possibility becomes large for the sintered body to reach a higher relative density. Specifically, it is considered that due to the calcining processing at 700°C, moistures are preliminarily desorbed and the amount of moistures decrease since the crystals themselves are stabilized due to crystal grain growth thereof to a somewhat degree, thus facilitating production of a favorable sintered body at the time of sintering thereafter. When a bulk plate is actually produced by CIP molding at 196 MPa (2 ton/cm²) and the heating process (950°C) after the calcined at 700°C, pulverized, and sieved (#32), the relative density thereof reached about 96%. Moreover, even when the powder calcined at 650°C is used, the relative density reached 95% and no internal defects exceeding a millimeter-size was observed.

As described above, a lower limit of the processing temperature in the calcining process, at which a high-density sintered body with no macro internal defects exceeding a millimeter-size can be obtained, is 650°C. As shown in Figs. 4, this condition matches the temperature range of the XRD analysis result in which the FWHM of the peak indicating the (012) orientation that appears at 22.3° to 22.4° becomes 0.19° or less. In other words, when the FWHM is 0.19° or less (within a range of 0.16° or more to 0.19° or less), a size of a primary crystal grain itself is still small, and a state where the progression of the sintering is facilitated relatively easily can be maintained. In addition, it becomes possible to produce a sintered body having a high density without forming macro internal defects by either of the vacuum hot pressing method and the sintering method.

Therefore, according to this embodiment, by calcining the Li₃PO₄ raw material powder at 650°C or more, it is possible to not only dehydrate sufficiently, but also induce crystal grain growth by the progression of the sintering so that more stable raw material powder can be prepared. The relative density of lithium phosphate sintered body produced by using the raw material powder subjected to the above-mentioned processing can reach a high relative density without forming macro internal defects within the bulk.

It should be noted that the FWHM in the XRD analysis of the Li₃PO₄ powder tends to narrow as the calcining temperature increases (Figs. 4). Therefore, it is speculated that a dehydration effect and an effect of preventing the formation of internal defects increase as the calcining temperature increases. However, when the temperature for calcining is too high, sintering and crystal grain growth are facilitated during calcining process. Then, the particle size of the raw material powder increases, curing of the particles progresses, and a compact cluster is formed. In this case, it becomes difficult to carry out pulverizing the calcined powder more smaller size and also becomes difficult to sieve stably the powder within desired particle size. Consequently, it becomes impossible to avoid a decrease in material usage rate (yield) and an elongation of the processing time required for obtaining a sintered body having a high density. Accordingly, in this embodiment, the upper limit of the temperature for calcining is set to be less than 850°C. Thus, the calcined powder can stably and easily be pulverized and sieved. The upper limit of the calcining temperature is more preferably set to 750°C.

Further, according to this embodiment, because the amount of moistures absorbed to the produced sintered body is extremely small, deterioration and hydrolysis are prevented and the condition of sintered body storage becomes easier. Moreover, when the sintered body is used as the sputtering target, moistures are hardly desorbed during sputtering operation, and a lithium compound thin film excellent in film quality can stably be formed. In addition, absence of the internal defect results in stabilized discharge.

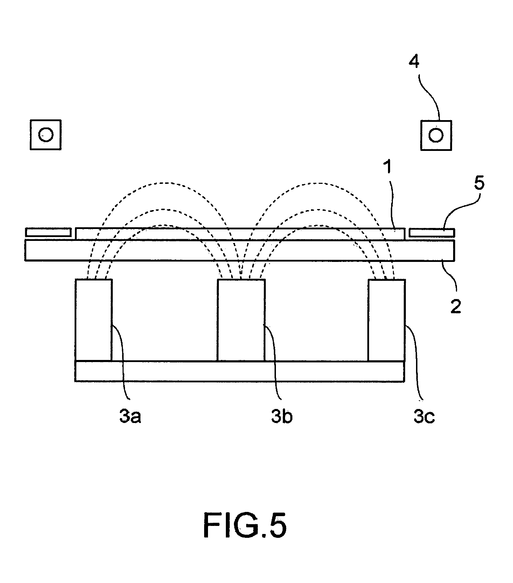

In Fig. 5, a schematic drawing showing main parts of a generally-used magnetron sputtering apparatus is illustrated (Japanese Patent Application Laid-open No. 06-10127). As shown in the figure, the magnetron sputtering apparatus includes a target 1, a backing plate 2 as a cathode electrode, permanent magnets 3a to 3c for forming magnetic field on a surface of the target 1, an anode electrode 4, and an earth shield 5. The target unit structured as described above is placed inside a vacuum chamber (not shown) so as to oppose a substrate on which film is deposited.

The lithium phosphate sintered body produced by the method according to the present invention is used as the target 1. The target 1 is produced by machining the sintered body (bulk plate) to a predetermined shape (diameter and thickness). The target 1 is bonded to the backing plate 2, using a low temperature brazing metal such as indium (In).

According to this embodiment, a high-density target material hardly having macro-size internal defects is produced. So, damage and breakage of the target material due to thermal shock can be prevented when brazing and soldering the target 1 to the backing plate 2. The target material 1 (the lithium phosphate sintered body) is sputtered and is deposited onto the substrate under a decompressed nitrogen gas atmosphere, to thus forming a lithium ion-conductive lithium phosphorous oxynitride thin film.

### (Examples)

Hereinafter, descriptions on examples of the present invention is given although not limited thereto.

A sintered body was produced by calcining, pulverizing and sieving, and sintering the Li₃PO₄ raw material powder (Sample A above) under the conditions of the following examples and comparative examples, and relative densities thereof and presence/absence of internal defects were evaluated. It should be noted that the defect was visually observed and its size was identified using a magnifying glass. The macro-size defect was measured using a scale. The results are shown in Table 1.

### (Example 1-1)

The raw material powder was calcined at 650°C in the atmosphere for 3 hours. The calcined powder was pulverized with a roll mill and sieved using a #32 filter, and was then subjected to CIP processing at 196 MPa (2 ton/cm²). After that, the powder was heated in the atmosphere under temperature conditions of 900°C, 950°C, and 1000°C to thus produce respective bulk plates of 300 mmϕ. Then, the resultant bulk plates were machined to the predetermined shape thereof, thereby obtaining respective sputtering targets.

The relative density of the bulk plate was 95% at 900°C, and no internal defect of 0.3 mmϕ or more was observed during the machining. The relative density of the bulk plate was 96% at 950°C, and no internal defect of 0.1 mmϕ or more was observed during the machining. Furthermore, the relative density of the bulk plate was 97% at 1000°C, and no internal defect of 0.1 mmϕ or more was observed during the machining.

### (Example 1-2)

A target plate was produced under the same conditions as those of Example 1-1 except that the temperature for calcining was set to 700°C and the heating temperature in the sintering process was set to 900°C. As a result, the relative density of the bulk plate was 95%, and no internal defect of 0.3 mmϕ or more was observed during and after the machining.

### (Example 1-3)

A target plate was produced under the same conditions as those of Example 1-1 except that the temperature for calcining was set to 750°C and the heating temperature in the sintering process was set to 900°C. As a result, the relative density of the bulk plate was 95%, and no internal defect of 0.3 mmϕ or more was observed during and after the machining.

### (Example 2-1)

The raw material powder was calcined at 650°C in the atmosphere for 3 hours. The calcined powder was pulverized with a roll mill and sieved using a #32 filter. After that, using the vacuum hot pressing method (19.6 MPa (0.2 ton/cm²)), bulk plates of 300 mmϕ each were produced under temperature conditions of 850°C, 900°C, 950°C, and 1000°C, respectively. Then, the resultant bulk plates were machined to the predetermined shape thereof, thereby obtaining respective sputtering targets.

The relative density of the bulk plate was 95% at 850°C, and no internal defect of 0.3 mmϕ or more was observed during and after the machining. The relative density of the bulk plate was 97% at 900°C, and no internal defect of 0.1 mmϕ or more was observed during and after the machining. The relative density of the bulk plate was a maximum value of 99% at 950°C, and no internal defect of 0.1 mmϕ or more was observed during and after machining. Furthermore, the relative density of the bulk plate was also 99% at 1000°C, and no internal defect of 0.1 mmϕ or more was observed during and after the machining.

### (Example 2-2)

A target plate was produced under the same conditions as those of Example 2-1 except that the temperature for calcining was set to 700°C and the temperature for vacuum hot pressing was set to 900°C. The relative density of the bulk plate was 97%, and no internal defect of 0.1 mmϕ or more was observed during and after the machining.

### (Example 2-3)

A target plate was produced under the same conditions as those of Example 2-1 except that the temperature for calcining was set to 750°C and the temperature for vacuum hot pressing was set to 900°C. The relative density of the bulk plate was 97%, and no internal defect of 0.1 mmϕ or more was observed during and after the machining.

### (Comparative Example 1-1)

A target plate was produced under the same conditions as those of Example 1-1 except that the temperature for heating in the sintering process was set to 850°C. The relative density of the bulk plate was as low as 91%, and no internal defect of 0.3 mmϕ or more was observed during and after the machining.

### (Comparative Example 1-2)

A bulk plate was produced under the same conditions as those of Example 1-1 except that the temperature for calcining was set to 600°C and the temperature for sintering was set to 850°C. A bulk plate in a pumice state where a low-density part is separated (see Fig. 7) was obtained.

### (Comparative Example 1-3)

The raw material powder was subjected to CIP processing at 196 MPa (2 ton/cm²) without being subjected to the calcining processing. After that, the compact was heated in the atmosphere at 850°C to thus produce a bulk plate of 300 mmϕ. As a result, a bulk plate in a pumice state where a low-density part is separated (see Fig. 7) was obtained.

### (Comparative Example 2-1)

In the vacuum hot pressing method (19.6 MPa (0.2 ton/cm²)), the raw material powder without calcining processing were applied to produce bulk plates of 300 mmϕ each, under temperature conditions of 700°C, 750°C, 800°C, 850°C, and 900°C, respectively. Then, the resultant bulk plates were machined to predetermined shape, thereby obtaining respective sputtering targets.

In case of the hot pressing temperature was 700°C, the relative density of the bulk plate was 95, but macro internal defects of a several-millimeter-size (see Figs. 6) were observed during and after the machining. In case of the hot pressing temperature was 750°C, the relative density of the bulk plate was 97, but macro internal defects were similarly observed during and after the machining. Furthermore, in case of the hot pressing temperatures were 800°C, 850°C, and 900°C, the relative densities of the bulk plates were 99%, but macro internal defects were similarly observed during and after the machining.

### (Comparative Example 2-2)

In the vacuum hot pressing method (19.6 MPa (0.2 ton/cm²)), the raw material powder with calcined at 500°C were applied to produce bulk plates of 300 mmϕ each, under temperature conditions of 800°C and 900°C, respectively. Then, the resultant bulk plates were machined to the predetermined shape thereof, thereby obtaining respective sputtering targets. The relative densities of the bulk plates were 99% under both temperature conditions, but macro internal defects each of a several-millimeter-size were observed during and after the machining.

### (Comparative Example 2-3)

In the vacuum hot pressing method (19.6 MPa (0.2 ton/cm²)), the raw material powder with calcined at 600°C were applied to produce bulk plates of 300 mmϕ each, under temperature conditions of 800°C and 900°C, respectively. Then, the resultant bulk plates were machined to the predetermined shape thereof, thereby obtaining respective sputtering targets. The relative densities of the bulk plates were 99% under both temperature conditions, but macro internal defects each of a several-millimeter-size were observed during and after the machining.

## Claims

1. A method of producing a lithium phosphate sintered body, comprising the steps of:
calcining raw material powder of Li₃PO₄ at a temperature set to be 650°C or more and less than 850°C;
pulverizing and sieving the calcined raw material powder; and
sintering the sieved raw material powder to a predetermined shape.

2. The method of producing a lithium phosphate sintered body according to claim 1, wherein in the step of calcining the raw material powder, a calcining temperature of the raw material powder is set to be 650°C or more and 750°C or less.

3. The method of producing a lithium phosphate sintered body according to claim 1, wherein the step of sintering the sieved raw material powder includes
press-molding the raw material powder; and
heating the press-molded raw material powder.

4. The method of producing a lithium phosphate sintered body according to claim 3, wherein in the step of sintering the sieved raw material powder, a heating temperature of the raw material powder is set to be 900°C or more and 1000°C or less.

5. The method of producing a lithium phosphate sintered body according to claim 1, wherein the step of sintering the sieved raw material powder is a hot pressing step.

6. The method of producing a lithium phosphate sintered body according to claim 5, wherein in the step of sintering the sieved raw material powder, a heating temperature of the raw material powder is set to be 850°C or more and 1000°C or less.

7. The method of producing a lithium phosphate sintered body according to claim 1, wherein each of the raw material powder has a maximum particle size of 400 µm or less.

8. A sputtering target constituted of a lithium phosphate sintered body produced by the method of producing a lithium phosphate sintered body according to claim 1, wherein the sputtering target has a relative density of 95% or more.
